(19) Europäisches Patentamt
European Patent Office
Office européen des brevets

(11) Publication number: **0 287 222 A2**

# (12) EUROPEAN PATENT APPLICATION

(21) Application number: 88302485.3

(51) Int. Cl.⁴: **G03F 7/10 , G03C 1/68**

(22) Date of filing: **22.03.88**

(30) Priority: **15.04.87 GB 8709050**

(43) Date of publication of application: **19.10.88 Bulletin 88/42**

(84) Designated Contracting States: **BE CH DE FR GB IT LI LU NL SE**

(71) Applicant: **AUTOTYPE INTERNATIONAL LIMITED**
**Grove Road**
**Wantage Oxfordshire OX12 7BZ(GB)**

(72) Inventor: **Agar, Barry**
**35 Stirlings Road**
**Wantage Oxfordshire OX12 7BB(GB)**
Inventor: **Smith, Neil David**
**71 Winchester Way**
**Wantage Oxfordshire OX12 9EW(GB)**
Inventor: **Steel, John**
**10 Bosleys Orchard Grove**
**Wantage Oxfordshire OX12 7JP(GB)**

(74) Representative: **Oliver, Roy Edward et al**
**POLLAK MERCER & TENCH High Holborn House 52-54 High Holborn**
**London WC1V 6RY(GB)**

## (54) Negative-working photoresists.

(57) A negative-working photoresist which can be developed bymeans of an aqueous developer is based upon cellulose ester carboxylates containing peroxide groups, a photoinitiator and a compound containing more than one polymerisable unsaturated group.

EP 0 287 222 A2

## PHOTORESISTS

The present invention relates to a photosensitive synthetic resin or polymer-containing composition, which has been found to give improved negative-working photoresists.

Such resists have a wide range of uses, for instance when applied to copper or copper-coated surfaces, for subsequent etching or plating operations, in the preparation of coloured images by pigmentation of the resist, either before or after imaging, in the preparation of various types of printing formes, including screen printing stencils, and in many other applications.

It is particularly desirable if, after imagewise exposure, such resists can be developed by means of aqueous developers. This avoids the use of solvents and so reduces the hazards associated with them, more readily complies with environmental protection laws and significantly reduces costs. The use of aqueous alkalies for this form of development has gained a ready acceptance. Normally, photosensitive compositions are used which include homopolymers or copolymers of relatively high molecular weight, containing carboxylic acid groups, carboxylic anhydride groups or similar groups which make the composition dissolve or at least swell when in contact with aqueous alkaline media. In conventional alkali-developable systems, the carboxylic group-containing polymer is admixed with low molecular weight unsaturated molecules which are capable of vinyl polymerisation, together with a photoinitiator which is capable of giving free radicals on exposure to actinic light and so cause photopolymerisation of the unsaturated compound. If the molecule contains more than one unsaturated group, cross-linking can occur. The inert polymer becomes trapped in a matrix of cross-linked polymer, thus increasing the efficiency of the photoreaction.

To increase the efficiency of the reaction still further, it is very desirable if the polymer contained in the mixture itself contains polymerisable unsaturated groups or is otherwise capable of participating in the photoreaction. If this can be achieved, the high molecular weight polymer chains themselves crosslink, the molecular weight rises very rapidly during the photoreaction and the efficiency of the photoreaction is greatly increased.

Recently, a new class of polymers, namely cellulose ester carboxylates, have become commercially available. These are readily solvent-soluble and, as well as hydroxyl and carboxyl functionality, also contain peroxide groups on the polymer molecule. This enables them to participate in thermal initiation of polymerisation, especially in the presence of a suitable catalyst, usually vanadium (US 4,603,160 and US 4,539,349).

Cellulose ester carboxylates exhibit no absorption at wavelengths between 250 nm and 450 nm and show no intrinsic photoactivity. However, it has now been discovered that, in the presence of a conventional photoinitiator absorbing between 250 nm and 450 nm to give free radicals, the peroxide groups on the polymer molecule also become activated and participate in the reaction. Based upon this discovery, it has been established that a mixture of a cellulose ester carboxylate and a conventional photoinitiator, when irradiated in the presence of a molecule containing more than one polymerisable unsaturated group, gives very efficient photopolymerisation. Presumably, this is because of the participation of the high-molecular-weight polymers in the cross-linking reaction. The carboxyl groups remain intact, enabling easy development of the unexposed areas by mild aqueous alkali solution.

This invention therefore seeks to provide a photopolymerisable composition having a high photographic speed and good adhesion to metallic and non-metallic surfaces, which is capable of aqueous alkaline development.

According to one aspect of the present invention, a photopolymerisable composition is provided, comprising:-

(i) a cellulose ester carboxylate of the general formula:

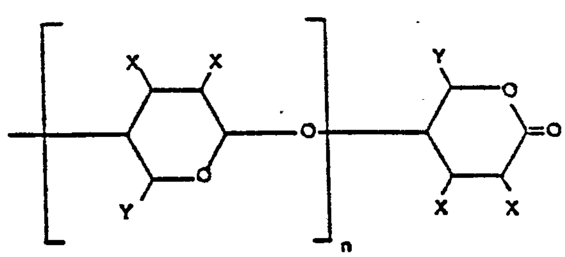

wherein X is the same or different and each represents a group selected from $-OOC.CH_3$, $-OOC.CH_2CH_3$, $-OOC.CH_2CH_2CH_3$ and -OH;

Y is the same or different and each represents a group selected from $-CH_2X$, $-CH_2OOH$ and -COOH;

n is an integer;

(ii) a polymerisation initiator comprising a material which, upon irradiation with actinic light, generates a free radical capable of initiating polymerisation; and

(iii) a compound containing more than one unsaturated group capable of radical polymerisation.

Preferably, the composition also contains a proportion of a monomer with only a single functionality.

Cellulose ester carboxylates are prepared by the oxidation of cellulose derivatives. The ester and hydroxyl contents of these polymers are similar to conventional cellulose esters, except that they have carboxylic acid and peroxide groups on the polymer chain. They include cellulose acetate butyrate carboxylate and cellulose acetate propionate carboxylate.

Photoinitiators suitable for use in the photosensitive compositions of the invention include compounds which, on exposure to actinic radiation, generate free radicals capable of polymerising monomers having at least one terminal vinyl group. These include compounds which undergo bond cleavage and also those types which undergo intermolecular H-abstraction. The former type are typified by acetophenone derivatives and the latter by benzophenone, thioxanthone and quinone derivatives. The efficiency of these photoinitiators may be improved by the inclusion of synergists, such as tertiary amines. Examples of photoinitiators include acetophenone, benzoin, benzoin ethers such as benzoin butyl ether, benzil, dimethylketal, diethoxyacetophenone, dichloroacetophenone, benzophenone, 2-isopropylthioxanthone and 4-phenylbenzophenone. Suitable synergists for use with hydrogen-abstracting types of photoinitiators include ethyl-4-dimethylaminobenzoate, 2-(n - butoxy)-ethyl-4-dimethylaminobenzoate and triisopropylamine.

Unsaturated compounds containing more than one unsaturated group capable of radical polymerisation include the epoxy-acrylates, urethane acrylates, polyester acrylates, polyether acrylates, the corresponding methacrylates, divinyl benzene and bisacrylamides or bismethacrylamides.

All the components of the system are soluble in organic solvents such as ketone solvents (e.g. methylethylketone and methyl-isobutylketone) and may be coated as a lacquer from such solutions.

Efficient development of the image by the removal of the unexposed areas of the resist may be effected by the use of mild aqueous alkaline solutions at an optimum pH of 9-10. The addition of surfactants tends to increase the efficiency of the development step and, although a reduction in pH value of the developer increases the time taken for development, careful selection of a suitable surfactant may enable acceptable development times to be achieved at pH values as low as 7.0.

In order that the invention may be fully appreciated, the following Examples are given, by way of illustration only. Examples 1, 2 and 6 illustrate the invention, while Examples 3 to 5, 7 and 8 are given by way of comparison and represent known formulations.

EXAMPLE 1

EXAMPLES 1 to 5 - PHOTOSENSITIVE LAYER FORMULATIONS

| | 1 | 2 | 3 | 4 | 5 |
|---|---|---|---|---|---|
| Cellulose acetate propionate carboxylate/peroxide polymer - Eastacel 13-20. | 7 | | | | |
| Cellulose acetate butyrate carboxylate/peroxide polymer - Eastacel 14-20. | | 7 | | | |
| Carboxylated acrylic polymer - Surcol 836W. | | | 7 | | |
| Modified shellac copal resin - Gompal 505 | | | | 7 | |
| 20% Hydrolysed polyvinyl acetate polymer solution - Alcotex 20-009. | | | | | 25 |
| Hydroxypropyl cellulose polymer - Klucel 'L'. | 2 | 2 | 2 | 2 | 2 |
| Trimethyl-propane triacrylate | 2.5 | 2.5 | 2.5 | 2.5 | 2.5 |
| Ethoxylated trimethyl-propane triacrylate | 2.5 | 2.5 | 2.5 | 2.5 | 2.5 |
| Isopropyl-thioxanthone | 0.18 | 0.18 | 0.18 | 0.18 | 0.18 |

EXAMPLE 1 (continued)

EXAMPLES 1 to 5 - PHOTOSENSITIVE LAYER FORMULATIONS

| | 1 | 2 | 3 | 4 | 5 |
|---|---|---|---|---|---|
| Ethyl-4-(dimethylamino)-benzoate | 1.8 | 1.8 | 1.8 | 1.8 | 1.8 |
| Methylated spirits | - | - | - | 131 | - |
| Methylethyl ketone | 131 | 131 | 131 | - | 113 |
| Phthalocyanine blue pigment - Microlith Blue 4G-K, except * = Microlith Blue 4G-A | 1.5 | 1.5 | 1.5 | 1.5* | 1.5 |

"Eastacel 13-20" and "Eastacel 14-20" (Eastrian Chemical Corp.), "Surcol 836W" (Allied Colloids), "Goripal 505" (K.P.S.), "Alcotex 20-009" (Harco), "Klucel L" (Hercules) and "Microlith" (Ciba Geigy) are Registered Trade Marks; "Alcotex 20-009" is supplied as a 28% solids solution in methanol.

Method

Each formulation was mixed for 10 minutes on high-shear dispersing equipment. The resultant solutions were then coated on to 175 micron "Melinex 505" (treated polyester base; Registered Trade Mark (I.C.I.)), using a wire-wound coating bar. Each coated base was then dried under a 60°C. fan heater. The dry coating weight obtained was 1.5 - 2 g.s.m., giving a photosensitive layer of 1 - 2 microns. An anti-blocking overcoat was then applied with a wire-wound coating bar. This was also dried under a 60°C. fan heater. The dry coating weight obtained was 3 - 3.5 g.s.m. giving an overall film thickness of 5 - 6 microns. The anti-blocking overcoat was made from:

| | Kgs. |
|---|---|
| 88% hydrolysed polyvinyl alcohol polymer - "Gohsenol GM-14L" (Registered Trade Mark - Nippon Gohsei) | 22.5 |
| Silica - "Aerosil 200" (Registered Trade Mark - Air Products) | 1.2 |
| Anti-foaming agent - "Surfynol PC" (Registered Trade Mark - Air Products) | 1.5 |
| Surfactant - "Gafen LS500" (Registered Trade Mark - G.A.F.); this was first converted to its Na salt and neutralised before addition to the formulation. | 0.3 |
| Water | 275 |

The ingredients were mixed for 10 minutes using a high-shear stirrer.

The resultant films were then exposed imagewise to actinic radiation, through a 0.15 density step tablet. The films were exposed on a Collyer 800 W. exposure unit, using a 365 nm. bulb. The distance between the light source and film was 50 cm. The exposure was measured at 0.61 µW/cm./sec. for 35 seconds, giving an exposure of 21.35 µW/cm.

The exposed films were then soaked in the following development solution, prepared using a standard laboratory stirrer. They were then removed and swabbed with cotton wool until a clean image was obtained. A reading was then taken from the step-wedge image.

| | |
|---|---|
| Wetting/Emulsification agent - "Nekal BX" (Registered Trade Mark - B.A.S.F.) | 96 |
| Water | 1154 |

Results

| | 1 | 2 | 3 | 4 | 5 |
|---|---|---|---|---|---|
| Development time/ secs. (Soak/Swab) | 150/60 | 150/60 | 120/40 | 15/15 | 60/30 |
| Step-wedge reading | 8 | 8 | 3 | 4 | 4 |

From these results, it can be seen that the two polymers containing peroxide group, Ex 1 and 2, give substantially increased photographic speeds.

EXAMPLES 6 to 8 - PHOTOSENSITIVE LAYER FORMULATIONS

The ingredients are the same as in Examples 1 to 5, except where indicated.

| | 6 | 7 | 8 |
|---|---|---|---|
| Cellulose acetate butyrate carboxylate acrylic polymer (Ex. 2) | 7 | | |
| Carboxylated acrylic polymer (Ex. 3) | | 7 | |
| 20% Hydrolysed polyvinyl acetate solution (Ex. 5) | | | 25 |
| Hydroxypropyl cellulose | 2 | 2 | 2 |
| Trimethylol-propane triacrylate | 2.5 | 2.5 | 2.5 |
| Ethoxylated trimethyl propane triacrylate | 2.5 | 2.5 | 2.5 |
| Benzil dimethyl ketal | 0.45 | 0.45 | 0.45 |
| Phtalocyanine blue pigment (Ex. 1-3 and 5) | 1.5 | 1.5 | 1.5 |
| Methyl-ethyl ketone | 130 | 130 | 112 |

Method

These formulations were coated and dried as described in Examples 1-5 and then overcoated with the anti-blocking formulation, as previously described.

These resultant films were then exposed imagewise to actinic radiation, through a 0.15 density step tablet.

The exposure was carried out on a 2 Kw. NuArc 'flip top' exposure unit. The distance between the light source and film was 50 cm. The exposure was measured at 1.6 µW/cm./sec. for 83 seconds, giving an exposure of 132.8 uW/cm.

The exposed films were then developed as described for Examples 1-5.

| Results | 6 | 7 | 8 |
|---|---|---|---|
| Development time/secs (Soak/Swab) | 150/80 | 120/40 | 60/30 |
| Step Wedge reading (0.15 density tablet) | 7 | 3 | 3 |

This shows that the increase in photographic speed is not dependent upon the type of photo initiation required.

**Claims**

1. A photopolymerisable composition, suitable for use as a negative-working photo-resist, characterised by comprising:

(i) a cellulose ester carboxylate of the general formula:

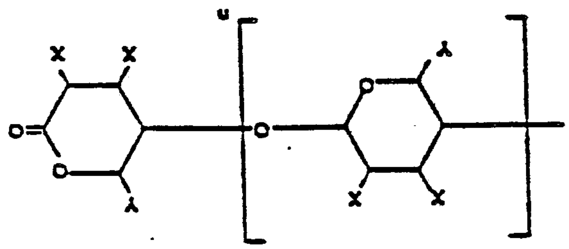

wherein X is the same or different and each represents a group selected from $-OOC.CH_3$, $-OOC.CH_2CH_3$, $-OOC.CH_2CH_2CH_3$ and -OH;

Y is the same or different and each represents a group selected from $-CH_2X$, $-CH_2OOH$ and -COOH;

n is an integer;

(ii) a polymerisation initiator comprising a material which, upon irradiation with actinic light, generates a free radical capabale of initiating polymerisation; and

(iii) a compound containing more than one unsaturated group capable of radical polymerisation.

2. A composition according to claim 1, wherein the cellulose ester carboxylate (i) is selected from cellulose acetate butyrate carboxylate and cellulose acetate propionate carboxylate.

3. A composition according to any preceding claim, wherein the polymerisation initiator (ii) is selected from acetophenone, benzophenone, thioxanthone and quinone derivatives.

4. A composition according to claim 3, wherein the initiator is selected from acetophenone, benzoin, benzoin ethers, benzil, dimethylketal, diethoxyacetophenone and dichloroacetophenone.

5. A composition according to claim 3, wherein the initiator is selected from benzophenone, 2-isopropylthionanthone and 4-phenyl-benzophenone.

6. A composition according to claim 5, wherein a tertiary amine synergist is included, whereby the efficiency of the initiator is improved.

7. A composition according to any preceding claim, wherein the polyunsaturated compound (iii) is selected from epoxy-acrylates, methane acrylates, polyester acrylates, polyether acrylates, the corresponding methacrylates, divinyl-benzene, biscacrylamides and bismethacrylamides.

8. A composition according to any preceding claim, which comprises a solution in an organic solvent.

9. A composition according to any preceding claim, wherein a monomer having a single functionality is included.

10. A method of manufacture of a photographic image, in which a photoresist composition is applied to a substrate, subjected to imagewise exposure and developed, characterised in that the composition comprises:

(i) a cellulose ester carboxylate of the general formula:

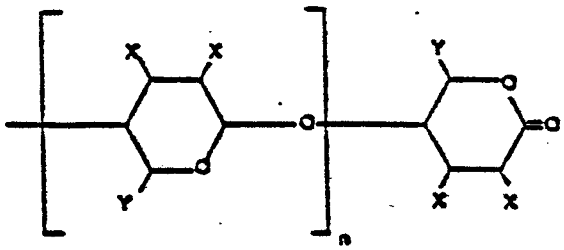

wherein X is the same or different and each represents a group selected from $-OOC.CH_3$, $-OOC.CH_2CH_3$, $-OOC.CH_2CH_2CH_3$ and $-OH$;

Y is the same or different and each represents a group selected from $-CH_2X$, $-CH_2OOH$ and $-COOH$;

n is an integer;

(ii) a polymerisation initiator comprising a material which, upon irradiation with actinic light, generates a free radical capable of initiating polymerisation; and

(iii) a compound containing more than one unsaturated group capable of radical polymerisation.